# EUROPEAN PATENT SPECIFICATION

(11) **EP 2 277 949 B1**
(45) Date of publication and mention of the grant of the patent: **04.03.2015**
(21) Application number: 09738867.2
(22) Date of filing: 30.04.2009
(51) Int. Cl.: C08L 53/02, C08F 297/04, C08K 3/22, C08L 27/12, C09K 5/08, H01L 23/373

(54) **RESIN COMPOSITION AND SHEET USING THE SAME**
HARZZUSAMMENSETZUNG UND FOLIE UNTER VERWENDUNG DAVON
COMPOSITION DE RÉSINE ET FEUILLE UTILISANT CELLE-CI

(30) Priority: 30.04.2008 JP 2008118793; 30.04.2008 JP 2008118859
(43) Date of publication of application: 26.01.2011
(73) Proprietor: Asahi Kasei E-materials Corporation, Tokyo 101-8101 (JP)
(72) Inventor: NODA Kazuya, Tokyo 101-8101 (JP); YASUI Takeshi, Tokyo 101-8101 (JP); KONOMI Yasuaki, Tokyo 101-8101 (JP); MIYAMOTO Akira, Tokyo 101-8101 (JP)
(74) Representative: Strehl Schübel-Hopf & Partner
(86) International application number: PCT/JP2009/058494
(87) International publication number: WO 2009/133930

(56) References cited:
- EP-A2- 0 273 516
- DE-A1- 19 941 180
- JP-A- 2001 247 870
- JP-A- 2001 310 974
- JP-A- 2003 113 318
- JP-A- 2003 313 431
- JP-A- 2003 313 431
- JP-A- 2004 079 641
- JP-A- 2006 233 126
- JP-A- 2006 233 126

## Description

### Technical Field

The present invention relates to a resin composition and a sheet using the same.

### Background Art

With the widespread use of digital home appliances, demands for high-speed and high-performance electrical and electronic equipment have been increased. Semiconductor devices that control these equipment electronically, such as large-scale integrations (LSI) and central processing units (CPU), require larger amounts of power because integration degree and operating speed of computers are increased. As a result, the amount of heat generation is increased, thereby causing defects in semiconductor devices in some cases. Illuminations, signboards, liquid crystal display backlight units, or the like using light-emitting diodes (LED) also require measures for heat dissipation to improve luminous efficiency of LEDs and to increase their lives.

Methods for dissipating heat from general electrical and electronic equipment include: installing a cooling component such as a heat sink in the equipment and air-cooling the heat sink forcibly with a cooling fan or the like; and using a heat conductive medium, such as silicone grease and a heat conductive sheet. The heat conductive media include the media disclosed in Patent Documents 1 to 5, for example.

### Citation List

### Patent Literature

Patent Document 1: JP-2000-150740A
Patent Document 2: JP-2004-146106A
Patent Document 3: JP-2007-39671A
Patent Document 4: JP-2003-313431A
Patent Document 5: JP-2004-352904A

JP 2006 233126 A discloses a resin composition comprising a block copolymer having an α-methylstyrene block and a conjugated diene block, a polyolefin-based resin and a metal hydrate which can be Mg(OH)₂.

DE 199 41 180 A1 discloses resin compositions comprising inter alia a block copolymer made of a vinyl aromatic compound and a conjugated diene compound, a softener for rubber and a metal hydrate which can be Mg(OH)₂.

EP 0 273 516 A2 discloses resin compositions comprising a specific vinyl aromatic-conjugated diene block copolymer, a plasticizer and Mg(OH)₂ as an inorganic filler.

JP 2001 247870 A discloses a polymer composition comprising, as a flame retardant, a polyorganosiloxane containing a metal element and a phenoxyphosphazen.

### Summary of Invention

### Technical Problem

However, when cooling small electrical equipment such as a laptop computer, and high-density mounting electronic equipment, for example, it is difficult to air-cool a heat sink forcibly with a cooling fan or the like because the space to install the cooling fan is limited. Therefore, the cooling method using a heat conductive medium is essential when cooling this type of equipment.

When using silicone grease as a heat conductive medium, however, the grease has poor work efficiency, protrudes after being applied to contaminate other parts, and has limitations on use under a highly weighted condition because of its poor cushioning characteristics, for example. For LED light source units equipped with LEDs on the surface of a substrate, for example, attempts to apply silicone grease between a heat sink and a metallic frame have been made to conduct heat efficiently. However, the grease, which has poor work efficiency and protrudes after being applied, needs to be improved.

A heat conductive sheet prepared by containing relatively highly heat-conductive filler in silicone rubber is mainly used for the heat conductive sheet. The heat conductive sheet made of silicone rubber, however, has a disadvantage in that silicone resin itself, which is a raw material of the sheet, is expensive. In addition, the sheet needs to go through a curing process (cross-linking process), which increases the number of processes and decreases the productivity. The sheet also has a problem in terms of cost. Furthermore, silicone resin contains low-molecular-weight siloxane therein. Therefore, the use of the sheet being attached to a heating element generates low-molecular-weight siloxane gas. The gas may attach to an electrode contact point or the like to generate silica dioxide, thereby causing a bad electrical contact. Furthermore, because of its low strength, the sheet has a problem in terms of handling property when it is made thin. The heat conductive sheet means a soft sheet that is interposed between a hard cooling component such as a heat sink, and a hard heating element to enhance the adjacency therebetween effectively. When the component and the element are adjacent to each other, heat can be conducted to the cooling component efficiently.

It is preferable that a heat conductive sheet have excellent heat conductivity and high toughness even when the sheet is made thin. The heat conductive sheets made of the heat conductive media disclosed in Patent Documents 1 to 5, however, have remarkably low sheet strength when the sheets are made thin. In this case, the sheets are likely to rupture and difficult to be reattached, which makes the work efficiency poor.

To solve the problems described above, an object of the present invention is to provide a resin composition that can form a heat conductive sheet having excellent heat conductivity and high toughness even when the sheet is made thin, and a sheet using the same.

### Solution to Problem

The present inventors have found, as a result of their extensive studies in view of the above problems, that a resin composition that can form a heat conductive sheet with both excellent heat conductivity and high toughness is obtainable with a copolymer having a specific structure, a softening agent for rubber, and metal hydroxide contained in a predetermined amount. Thus, the present invention has been completed.

The invention provides a resin composition including 1 to 20% by mass of (A) a copolymer containing a conjugated diene unit and a vinyl aromatic compound unit, 1 to 20% by mass of (B) a softening agent for rubber, and 70 to 95% by mass of (C) aluminum hydroxide, in which (A) the copolymer containing the conjugated diene unit and the vinyl aromatic compound unit includes a plurality of polymer blocks of the vinyl aromatic compound unit, and
wherein the (C) aluminum hydroxide contains Na₂O in a concentration of 0.2 % by mass or less.

The resin composition of the present invention makes it possible to form a soft sheet that has excellent heat conductivity and high toughness by having the structure described above. The resin composition of the present invention also makes it possible to continuously produce thin sheets efficiently by extrusion forming, for example. Furthermore, the resin composition of the present invention also enables a thin sheet to maintain high toughness. A sheet formed with the composition of the present invention has excellent elongation as well as high strength. The sheet with high strength and excellent elongation has high adhesion to an object and performs heat dissipation efficiently when the sheet is used as a heat conductive sheet.

In particular, when a heat conductive sheet is used for a light source that uses LEDs and has an elongated shape, for example, the sheet making the LED substrate and the heat sink stick together is required to be "small in width" in accordance with the shape of the light source and be "thin" to reduce thermal resistance and enhance heat conductive efficiency. A related-art heat conductive sheet that is made small in width and thin in view of the foregoing, however, ends up with remarkably low sheet strength. As a result, the sheet is likely to rupture and difficult to be reattached, which makes the work efficiency poor. Thus, an improvement in handling property of the sheet has been required. With the resin composition of the present invention having the structure described above, it is possible to form a small-in-width and thin sheet that has sufficient toughness and heat conductivity. The sheet can be prepared by: dissolving or dispersing the resin composition of the present invention in a solvent, casting the resultant solution on a film or an exfoliate paper and then volatilizing acid from the solvent, or impregnating a glass cloth or an organic fiber cloth with the solution and then removing the solvent. In this case, the thickness of the sheet is preferably 0.01 to 0.3 mm, more preferably 0.03 to 0.2 mm, and still preferably 0.05 to 0.13 mm.

Although the reason for such advantageous effects achieved by having the structure is not necessarily obvious, it is considered that the excellent heat conductivity is attributed to a large content of 70 to 95% by mass of (C) the aluminum hydroxide. It is also considered that by combining (A) the copolymer containing the conjugated diene unit and the vinyl aromatic compound unit, which has a specific structure, and (B) the softening agent for rubber, specific affinity for (C) the aluminum hydroxide and flexible ductility characteristics are achieved, and that the sheet can maintain high toughness even when the sheet is made thin.

In the resin composition, (C) the aluminum hydroxide contains Na₂O in a concentration of 0.2% by mass or less. Such a resin composition makes it possible to form a sheet that has excellent electrical insulation as well as excellent heat conductivity and high toughness.

In the resin composition, (C) the aluminum hydroxide is preferably formed in particles whose average particle diameter is 10 to 80 µm. Such a resin composition makes it possible to form a sheet that has high fire resistance as well as higher toughness.

In the resin composition, (C) the aluminum hydroxide is preferably formed in particles and includes a first aluminum hydroxide whose average particle diameter is 20 µm or larger and a second aluminum hydroxide whose average particle diameter is smaller than 20 µm, a weight ratio of the first aluminum hydroxide to the second aluminum hydroxide being 100/1 to 100/80. Such a resin composition makes it possible to form a sheet that has higher fire resistance as well as more excellent heat conductivity.

The resin composition of the present invention comprises (C) aluminum hydroxide as a metal oxide. With such a resin composition, a sheet formed with the resin composition has high strength when the sheet is made thin as well as excellent fire resistance.

In the resin composition, (A) the copolymer containing the conjugated diene unit and the vinyl aromatic compound unit is preferably a hydrogenated copolymer prepared by hydrogenating a copolymer of conjugated diene and a vinyl aromatic compound and/or a modified hydrogenated copolymer prepared by introducing a functional group to a copolymer of conjugated diene and a vinyl aromatic compound and hydrogenating the copolymer. Such a resin composition makes it possible to form a sheet that has high thermal resistance (heat deterioration resistance) in long-term use.

In the resin composition, (A) the copolymer containing the conjugated diene unit and the vinyl aromatic compound unit preferably contains the vinyl aromatic compound unit in an amount of 30% by mass or more and 90% by mass or less. Such a resin composition makes it possible to form a sheet that has excellent flexibility and high flex resistance.

In the resin composition, (A) the copolymer containing the conjugated diene unit and the vinyl aromatic compound unit preferably contains the polymer blocks of the vinyl aromatic compound unit in an amount of 40% by mass or less. Such a resin composition makes it possible to form a sheet that achieves a good balance between blocking resistance and flexibility. Thus, such a resin composition has high productivity, and is preferred.

In the resin composition, (A) the copolymer containing the conjugated diene unit and the vinyl aromatic compound unit preferably has a weight-average molecular weight of 5 × 10⁴ to 100 × 10⁴. Such a resin composition makes it possible to form a sheet that achieves a good balance between toughness and flexibility as well as high processing productivity when the sheet is formed.

In the resin composition, (A) the copolymer containing the conjugated diene unit and the vinyl aromatic compound unit preferably has a hydrogenated rate of a double bond derived from conjugated diene of 10% or more. Such a resin composition makes it possible to form a sheet that has high aging resistance.

In the resin composition, (A) the copolymer containing the conjugated diene unit and the vinyl aromatic compound unit preferably includes a random copolymer block of conjugated diene and a vinyl aromatic compound. Such a resin composition further improves the affinity between (C) the metal hydroxide and (A) the copolymer containing the conjugated diene unit and the vinyl aromatic compound unit, making it possible to produce a flexible and tough sheet with a smooth surface.

The resin composition preferably further contains (D) fluororesin and/or modified fluororesin in an amount of 0.01 to 5% by mass. Such a resin composition makes it possible to form a sheet that has high fire resistance and achieves V0 fire resistance stably.

The resin composition preferably has heat conductivity of 1.0 W/m·K or more. When using a sheet formed with such a resin composition as a heat conductive sheet, it can achieve an effective heat-conductive function.

The present invention provides a sheet produced by forming the resin composition into a sheet with a thickness of 0.8 mm or smaller. Such a thin sheet has low thermal resistance and an excellent heat-conductive function. Because the sheet is formed with the resin composition, the sheet has sufficiently high toughness even when its thickness is 0.8 mm or smaller. Therefore, the sheet is preferably used as a heat conductive sheet.

The present invention provides a sheet that is produced by forming the resin composition into a sheet and that has thermal resistance in a direction perpendicular to the sheet surface of 5 °C/W or lower as measured by a steady state method conforming to ASTM D5470. Such a sheet with low thermal resistance is preferably used as a heat conductive sheet.

The present invention provides a sheet that is produced by forming the resin composition into a sheet and that has yield stress of 1.0 MPa or more and rupture elongation of 30% or more as measured at 23°C and a rate of pulling of 100 mm/min conforming to ISO 527-1. Because such a sheet has high strength and excellent elongation, the sheet is excellent in handling property, has high adhesion to an object, and performs heat dissipation efficiently when the sheet is used as a heat conductive sheet.

The present invention provides a sheet that is produced by forming the resin composition into a sheet and that includes a glass fiber cloth and/or an organic fiber cloth. Such a sheet is tough enough to be used as a heat conductive sheet even when its thickness is 10 to 300 µm, and is excellent in dimensional stability.

The sheet is preferably used for LED components.

### Advantageous Effects of Invention

The present invention provides a resin composition that can form a heat conductive sheet having excellent heat conductivity and high toughness even when the sheet is made thin, and a sheet using the same.

### Brief Description of Drawings

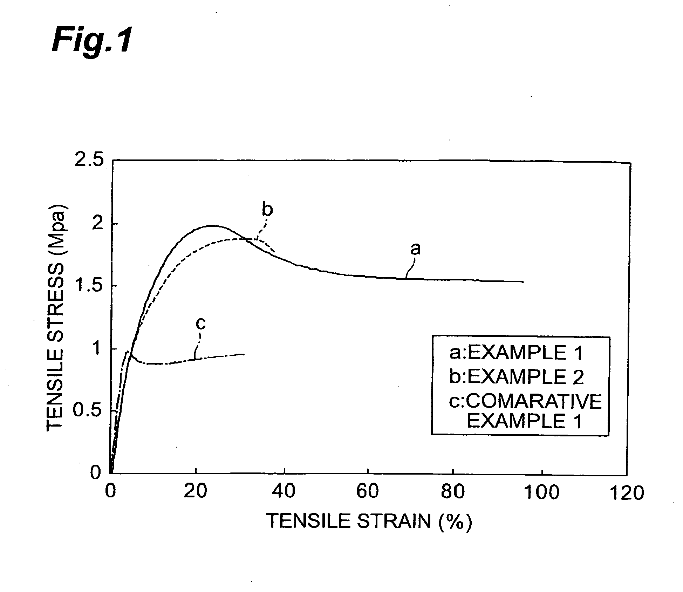

[FIG 1] FIG 1 is a diagram showing stress-strain (S-S) curves of each resin composition in example 1, example 2, and comparative example 1.

### Description of Embodiments

Preferred embodiments of the present invention will be described in detail.

A resin composition according to the present embodiment includes 1 to 20% by mass of (A) a copolymer containing a conjugated diene unit and a vinyl aromatic compound unit (hereinafter, referred to as "component A"), 1 to 20% by mass of (B) a softening agent for rubber (hereinafter, referred to as "component B"), and 70 to 95% by mass of (C) metal hydroxide (hereinafter, referred to as "component C"), in which the component A has a plurality of polymer blocks of the vinyl aromatic compound unit, wherein the (C) metal hydroxide is aluminum hydroxide.

The component A is a copolymer containing the conjugated diene unit and the vinyl aromatic compound unit, and has the plurality of polymer blocks of a vinyl aromatic compound. The component is not particularly restricted as long as it has such a structure. A copolymer prepared by copolymerizing conjugated diene and the vinyl aromatic compound can be used, for example.

The component A, which has the plurality of polymer blocks of the vinyl aromatic compound, preferably includes two to six polymer blocks, more preferably two to four polymer blocks, and still more preferably two to three polymer blocks, and most preferably two polymer blocks.

As for the component A, styrene elastomer is particularly preferred, which includes, for example, styrene-butadiene-styrene block copolymer (SBS), styrene-isoprene-styrene block copolymer (SIS), styrene-ethylene/butylene-styrene block copolymer (SEBS), and styrene-ethylene/propylene-styrene block copolymer (SEPS). The component A is preferably a hydrogenated copolymer and/or a modified hydrogenated copolymer prepared by hydrogenating a copolymer of conjugated diene and a vinyl aromatic compound, and more preferably a hydrogenated copolymer and/or a modified hydrogenated copolymer including a styrene/butadiene random copolymer. The hydrogenated copolymer means a polymer prepared by hydrogenating a copolymer of conjugated diene and a vinyl aromatic compound; and the modified hydrogenated copolymer means a polymer prepared by introducing a functional group to a copolymer of conjugated diene and a vinyl aromatic compound and then hydrogenating the copolymer.

The conjugated diene is diolefin having a pair of conjugated double bonds (two double bonds binding in a conjugated state). Examples of the conjugated diene include 1,3-butadiene, 2-methyl-1, 3-butadiene (isoprene), 2,3-dimethyl-1, 3-butadiene, 1,3-pentadiene, 2-methyl-1,3-pentadiene, and 1,3-hexadiene. In particular, 1,3-butadiene and 2-methyl-1,3-butadiene (isoprene) are commonly available. These conjugated dienes can be used alone or in combination of two or more.

The vinyl aromatic compound means a compound having a vinyl group and an aromatic ring. Examples of he vinyl aromatic compounds include styrene, α-methylstyrene, p-methylstyrene, divinylbenzene, 1,1-diphenylethylene, N,N-dimethyl-p-aminoethylstyrene, and N,N-diethyl-p-aminoethylstyrene. These vinyl aromatic compounds can be used alone or in combination of two or more.

The component A preferably contains the vinyl aromatic compound unit in an amount of 30% by mass or more and 90% by mass or less, more preferably 45% by mass or more and 90% by mass or less, and still more preferably 45% by mass or more and 86% by mass or less. Within this range, the resin composition having excellent flexibility and high flex resistance or the like can be obtained. The content of the vinyl aromatic compound unit can be measured by using a nuclear magnetic resonator (NMR).

The component A preferably contains the polymer blocks of the vinyl aromatic compound in an amount of 40% by mass or less. Within this range, the resin composition has good flexibility and high blocking resistance. The blocking resistance is an important property to improve the productivity of the resin composition.

To produce a copolymer of conjugated diene and a vinyl aromatic compound having high blocking resistance, the content of the polymer blocks of the vinyl aromatic compound is preferably 10 to 40% by mass, more preferably 13 to 37% by mass, and most preferably 15 to 35% by mass.

To produce a copolymer of conjugated diene and a vinyl aromatic compound having excellent flexibility, the content of the polymer blocks of the vinyl aromatic compound is preferably less than 10% by mass, more preferably 8% by mass or less, and most preferably 5% by mass or less.

The content of the polymer blocks of the vinyl aromatic compound can be measured by using the weight of the polymer block component made of the vinyl aromatic compound (however, the polymer component made of the vinyl aromatic compound having an average degree of polymerization of approximately 30 or lower is removed), prepared by a method in which a pre-hydrogenated copolymer is oxidatively decomposed by tertiary-butyl hydroperoxide with osmium tetroxide as a catalyst (the method described in I. M. KOLTHOFF, etal., J. Polym. Sci. 1,429 (1946)). The content can be calculated by the following formula:

Content of the polymer block made of the vinyl aromatic compound (% by mass) = [(Mass of the polymer block made of the vinyl aromatic compound in the copolymer of conjugated diene and the vinyl aromatic compound) / (Mass of the copolymer of conjugated diene and the vinyl aromatic compound)] × 100

The blocking rate of the vinyl aromatic compound in the component A is preferably 40% by mass or less, more preferably 20% by mass or less, and still more preferably 18% by mass or less. The blocking rate as used herein means the rate of the amount of the polymer blocks of the vinyl aromatic compound to the whole amount of the vinyl aromatic compound in the copolymer of conjugated diene and the vinyl aromatic compound. The rate is preferably within the range to produce the composition having good flexibility.

The copolymer of the conjugated diene and the vinyl aromatic compound preferably contains the vinyl aromatic compound unit in an amount of 5% by mass or more in addition to the polymer blocks of the vinyl aromatic compound. In other words, the content of the polymer component made of the vinyl aromatic compound that has an average degree of polymerization of lower than 30 and that is not considered as the polymer block is preferably 5% by mass or more. If the content of the vinyl aromatic compound unit other than the polymer block made of the vinyl aromatic compound is 5% by mass or more, the thermal resistance is improved in the copolymer of the conjugated diene and the vinyl aromatic compound. In this case, a part other than the polymer block made of the vinyl aromatic compound can be prevented from being crystallized, which makes the copolymer excellent in flexibility. In addition, because a large amount of filler can be contained, the copolymer is excellent in heat conductivity.

The weight-average molecular weight of the component A is preferably 5 × 10⁴ to 100 × 10⁴, more preferably 8 × 10⁴ to 80 × 10⁴, and still more preferably 9 × 10⁴ to 30 × 10⁴. When using the copolymer of the conjugated diene and the vinyl aromatic compound that contains the polymer blocks of the vinyl aromatic compound in an amount of 10 to 40% by mass, the weight-average molecular weight thereof is preferably 10 × 10⁴ or more and 50 × 10⁴ or less, more preferably 13 × 10⁴ to 40 × 10⁴, and still more preferably 15 × 10⁴ to 30 × 10⁴. The range is preferred, because the copolymer whose weight-average molecular weight is 5 × 10⁴ or more has high toughness, and the copolymer whose weight-average molecular weight is 100 × 10⁴ or less has excellent flexibility. When the weight-average molecular weight is 5 × 10⁴ to 100 × 10⁴, because the copolymer contains a small amount of low-molecular-weight component, a volatile component thereof is small.

The molecular weight distribution of the component A (Mw/Mn) (the rate of the weight-average molecular weight (Mw) to the number-average molecular weight (Mn)) is preferably 1.01 to 8.0, more preferably 1.1 to 6.0, and still more preferably 1.1 to 5.0 in terms of forming processability. The form of the molecular weight distribution measured by gel permeation chromatography (GPC) is not particularly restricted. Although the component A can have a polymodal molecular weight distribution with more than one peak, it preferably has a monomodal molecular weight distribution with one peak.

The molecular weight of the component A is the weight-average molecular weight calculated by: performing a measurement by GPC; and then calculating the peak molecular weight of the chromatogram using a calibration curve obtained by measurement of commercially available standard polystyrene (which the calibration curve is prepared by using the peak molecular weight of the standard polystyrene). The molecular weight distribution of the copolymer of the conjugated diene and the vinyl aromatic compound can be measured by GPC in the same manner.

In each of the hydrogenated copolymer and the modified hydrogenated copolymer, a hydrogenated rate of a double bond derived from conjugated diene in a pre-hydrogenated copolymer is preferably 10% or more, more preferably 75% or more, and still more preferably 85% or more. When the hydrogenated rate is 10% or more, the copolymers exhibit no reduction in flexibility, strength, and elongation because of heat deterioration and have high thermal resistance. To produce a heat dissipation material with high thermal resistance, the hydrogenated rate is preferably 85% or more, more preferably 90% or more, and still more preferably 95% or more. To produce a heat dissipation material with high weatherability, the hydrogenated rate is preferably 75% or more, more preferably 85% or more, and still more preferably 90% or more. When performing cross-linking, the hydrogenated rate is preferably 98% or less, more preferably 95% or less, and still more preferably 90% or less.

The hydrogenated rate of the double bond derived from conjugated diene as used herein means the rate of the hydrogenated double bond in the hydrogenated copolymer and the modified hydrogenated copolymer to the double bond of conjugated diene contained in the pre-hydrogenated copolymer and the modified pre-hydrogenated copolymer, respectively.

The hydrogenated rate of the hydrogenated copolymer and the modified hydrogenated copolymer can be measured by using the NMR.

The hydrogenated rate of an aromatic double bond derived from the vinyl aromatic compound in the copolymer is not particularly restricted. The rate is preferably 50% or less, more preferably 30% or less, and still more preferably 20% or less.

The component A particularly preferably has at least one structure selected from general formulas (i) to (v) below. The component A can be a mixture of a plurality of types of the following structures in a predetermined proportion as well.
(i) B
(ii) B - A
(iii) B - A - B
(iv) (B - A)ₘ - Z
(v) (B - A)ₙ - Z - Aₚ

In the formulas, B represents a random copolymer block of conjugated diene and a vinyl aromatic compound (hereinafter, referred to as "block B"), and A represents a vinyl aromatic compound polymer block (hereinafter, referred to as "block A"). m represents an integer equal to or more than 2, and n and p each represents an integer equal to or more than 1. Z represents a coupling agent residue. The coupling agent residue means a residue of a coupling agent made of a polyhalogen compound, acid esters, or the like, the agent being used for binding a plurality of copolymers of conjugated diene and the vinyl aromatic compound between blocks A-A, blocks B-B, or blocks A-B. The coupling agent residue is m valence in (iv), and n + p valence in (v).

In the general formulas, the vinyl aromatic compound in the block B may be distributed uniformly or in a tapered shape. In other words, a sequence of monomer unit of the vinyl aromatic compound may be any of a head-head structure, a tail-tail structure, and a head-tail structure. The block B can have a plurality of portions in which the vinyl aromatic compound is distributed uniformly and/or in a tapered manner. m represents an integer equal to or more than 2, and preferably an integer of 2 to 10; and n and p each represents an integer equal to or more than 1, and preferably an integer of 1 to 10. By making the block B into a random structure of the conjugated diene and the vinyl aromatic compound, crystallized portions in the copolymer can be reduced as much as possible or eliminated. As a result, a large amount of filler can be contained.

The modified hydrogenated copolymer has a functional group in the copolymer chain as described above. The functional groups include those selected fro, for example, a hydroxyl group, a carboxyl group, a carbonyl group, a thiocarbonyl group, an acid halide group, an acid anhydride group, a carboxylic acid group, a thiocarboxylic acid group, an aldehyde group, a thioaldehyde group, a carboxylic acid ester group, an epoxy group, a thioepoxy group, a sulfide group, an isocyanate group an isothiocyanate group, an amide group, a sulfonic acid group, a sulfonic acid ester group, a phosphoric acid group, a phosphoric acid ester group, an amino group, an imino group, a nitrile group, a pyridyl group, a quinoline group, a silicon halide group, a silanol group, an alkoxysilane group, a tin halide group, an alkoxytin group, and a phenyltin group. The modified hydrogenated copolymer preferably has at least one functional group selected from a hydroxyl group, an amino group, an epoxy group, a silanol group, or an alkoxysilane group, and more preferably has at least one functional group selected from a hydroxyl group, an amino group, or an epoxy group.

The modified hydrogenated copolymer can be prepared by reacting a denaturant containing these functional groups with a copolymer when the polymerization is completed. The modified hydrogenated copolymer can be prepared, for example, by additional reaction of a denaturant containing a functional group with a living terminal of a pre-hydrogenated copolymer prepared by using an organolithium compound as a polymerization catalyst and hydrogenation of the resultant copolymer.

In another method, the modified hydrogenated copolymer is prepared by reaction (metalation reaction) of an organic alkali metal compound such as an organolithium compound with a hydrogenated copolymer and additional reaction of a denaturant containing a functional group with the copolymer to which the organic alkali metal is added.

The hydrogenated copolymer and/or the modified hydrogenated copolymer preferably have substantially no crystallization peak within the range of -50°C to 100°C in the differential scanning calorimetry (DSC method). Having substantially no crystallization peak within the range of -50°C to 100°C means that no peak caused by crystallization is found within the temperature range, or that, even when a peak caused by the crystallization is found, the heat quantity at the crystallization peak in the crystallization is smaller than 3 J/g. By reducing as much as possible or eliminating crystallized portions, it is possible to mix a large amount of filler, which cannot infiltrate to the crystallized portions. Furthermore, if the present embodiment has crystallized portions, the embodiment formed into a sheet tends to have low surface smoothness, which is considered to be caused by a large volume contraction in the crystallization. Therefore, the component A having substantially no crystallization peak is preferably applicable to a heat conductive sheet.

At least one peak of loss tangent (tanδ) in a dynamic viscoelasticity spectrum of the hydrogenated copolymer and/or the modified hydrogenated copolymer preferably exists from -30°C to 80°C, more preferably from -20°C to 70°C, and still more preferably from -20°C to 50°C. The peak of tanδ existing in the range from -30°C to 80°C is a peak originated in the block B. With at least one peak of tanδ existing in the range from -30°C to 80°C, the copolymers have excellent flexibility and high toughness.

A microstructure (the rate of cis, trans, and vinyl) of the conjugated diene portion in the component A can be optionally changed by using a later-described polar compound or the like, and is not particularly restricted.

In general, when using 1,3-butadiene for the conjugated diene, the content of 1,2-vinyl bond is preferably 5 to 80%, and more preferably 10 to 60%, with respect to 100% of the conjugated diene portion. When using isoprene or a combination of 1,3-butadiene and isoprene for the conjugated diene, the sum of the content of 1,2-vinyl bond and 3,4-vinyl bond is preferably 3 to 75%, and more preferably 5 to 60%. Hereinafter, the sum of the content of 1,2-vinyl bond and 3,4-vinyl bond (the content of 1,2-vinyl bond when using 1,3-butadiene for the conjugated diene) is referred to as the vinyl bond content in the present invention.

The vinyl bond content derived from the conjugated diene in the component A can be measured by using the NMR.

The difference between the maximum value and the minimum value of the vinyl bond content in each molecular chain in the component A is preferably less than 10%, more preferably 8% or less, and still more preferably 6% or less. The vinyl bond in the copolymer chain can be distributed uniformly or in a tapered shape. In other words, a sequence of a vinyl bond (double bond) caused by conjugated diene polymerization can be any of a head-head structure, a tail-tail structure, and a head-tail structure. The difference between the maximum value and the minimum value of the vinyl bond content as used herein means the difference between the maximum value and the minimum value thereof determined by polymerization conditions, that is, the type and the quantity of vinyl amount adjuster, and the polymerization temperature.

The difference between the maximum value and the minimum value of the vinyl bond content in the conjugated diene polymer chain can be controlled, for example, by the polymerization temperature when the conjugated diene is polymerized or when the conjugated diene and the vinyl aromatic compound are copolymerized. When the type and the quantity of the vinyl amount adjuster such as tertiary amine compound or an ether compound are fixed, the content of the vinyl bond incorporated in the polymer chain during polymerization is determined by the polymerization temperature. Therefore, a polymer isothermally polymerized has the vinyl bond that is dispersed uniformly. By contrast, a polymer polymerized at elevated temperature has a difference in the vinyl bond content in each molecular chain such that the vinyl bond content is made higher at an early stage (polymerized at a low temperature) and made lower at a latter stage (polymerized at a high temperature). By hydrogenating the copolymer having such a structure, the hydrogenated copolymer and the modified hydrogenated copolymer with a difference in the vinyl bond content in each molecular chain can be obtained.

In the present embodiment, the pre-hydrogenated copolymer of the conjugated diene and the vinyl aromatic compound is prepared by anionic living polymerization using an initiator such as an organic alkali metal compound in a hydrocarbon solvent, for example. Examples of the hydrocarbon solvent include: aliphatic hydrocarbons such as n-butane, isobutane, n-pentane, n-hexane, n-heptane, and n-octane; alicyclic hydrocarbons such as cyclohexane, cycloheptane, and methylcycloheptane; and aromatic hydrocarbons such as benzene, toluene, xylene, and ethylbenzene.

The initiator includes an aliphatic hydrocarbon alkali metal compound, an aromatic hydrocarbon alkali metal compound, and an organic amino alkali metal compound, which are generally known to have anion polymerization activity with respect to the conjugated diene and a vinyl aromatic compound. Alkali metals contained in the initiator include lithium, sodium, and potassium. The organic alkali metal compound is preferably aliphatic and aromatic hydrocarbon lithium compounds with carbon atoms of 1 to 20, which include a compound containing a lithium in a molecule, and a dilithium compound, a trilithium compound, and a tetralithium compound containing a plurality of lithium in a molecule.

More specifically, the aliphatic and aromatic hydrocarbon lithium compounds include n-propyllithium, n-butyllithium, sec-butyllithium, tert-butyllithium, n-pentyllithium, n-hexyllithium, benzillithium, phenyllithium, tolyllithium, a reaction product of diisopropenylbenzene and sec-butyllithium, and a reaction product of divinylbenzene, sec-butyllithium, and a small amount of 1,3-butadiene. The followings can be used as well: 1-(t-butoxy)propyllithium and a lithium compound prepared by introducing one to several molecules of isoprene monomers to improve the solubility, which is disclosed in US Patent No. 5,708,092; alkyllithium containing a siloxy group such as 1-(t-butyldimethylsiloxy)hexyllithium disclosed in British Patent No. 2,241,239; and alkyllithium containing an amino group disclosed in US Patent No, 5,527,753; and aminolithium such as lithium diisopropylamide, and lithium hexamethyldisilazide.

When copolymerizing the conjugated diene and the vinyl aromatic compound using an organic alkali metal compound as a polymerization initiator in the present embodiment, a tertiary amine compound or an ether compound can be added as a modifier to adjust the content of the vinyl bond (1,2 bond or 3,4 bond) originated in the conjugated diene incorporated in the polymer, and random copolymerization of the conjugated diene and the vinyl aromatic compound.

The method for copolymerizing the conjugated diene and the vinyl aromatic compound using an organic alkali metal compound as a polymerization initiator in the present embodiment may be batch polymerization, continuous polymerization, or a combination thereof. The continuous polymerization is particularly suitable in terms of adjustment of molecular weight distribution within an appropriate range. The polymerization temperature is generally 0°C to 180°C, and preferably 30°C to 150°C. The time required for the polymerization, which depends on the conditions, is generally within 48 hours, and particularly preferably 0.1 to 10 hours. The polymerization is preferably performed under an inert gas atmosphere of nitrogen gas or the like. The polymerization pressure is not particularly restricted as long as the pressure is sufficient for maintaining the monomer and the solvent in a liquid phase within the polymerization temperature range. Attention should be paid so that any impurities, for example, water, oxygen, and carbon dioxide, which inactivate the solvent or the living polymer may not enter the polymerization system.

A coupling reaction can be performed by adding a coupling agent having two or more functional groups in a necessary amount at the end of the polymerization. The coupling agent can be any of commonly known agents, and is not particularly restricted. Such coupling agents include: a dihalide compound such as dimethyldichlorosilane and dimethyldibromosilane, and acid esters such as methyl benzoate, ethyl benzoate, phenyl benzoate, and phthalates.

The polyfunctional coupling agent having three or more functional groups can be any of commonly known agents, and is not particularly restricted. Examples of such coupling agents include: trivalent or higher polyalcohols; multivalent epoxy compound, such as epoxidized soybean oil, and bisphenol A diglycidle; halogenated silicon compound represented by the general formula: R₍₄₋ₙ₎SiXₙ (wherein R represents a hydrocarbon group with a carbon atoms of 1 to 20, X represents a halogen, and n represents 3 or 4); and halogenated tin compound. Examples of the halogenated silicon compounds include methylsilyl trichloride, t-butylsilyl trichloride, silicon tetrachloride, and bromides thereof. Examples of the halogenated tin compounds include polyvalent halogen compounds such as methyltin trichloride, t-butyltin trichloride, and tin tetrachloride. Dimethyl carbonate and diethyl carbonate, for example, can be used as well.

In the present embodiment, the denaturants used for producing the modified hydrogenated copolymer having at least one functional group selected from a hydroxyl group, an epoxy group, an amino group, a silanol group, or an alkoxysilane group include the denaturant disclosed in JP-H4-39495B.

A hydrogenation catalyst used for producing the hydrogenated copolymer and modified hydrogenated copolymer is not particularly restricted. The following catalysts can be used, for example.
(1) a supported heterogeneous hydrogenation catalyst composed of a metal such as Ni, Pt, Pd, and Ru, supported on carbon, silica, alumina, diatomaceous earth, or the like.
(2) a so-called Ziegler type hydrogenation catalyst composed of a transition metal salt, for example, an organic acid salt or an acetylacetone salt of Ni, Co, Fe, Cr, or the like, and of a reducing agent such as an organoalminum.
(3) a homogenous hydrogenation catalyst such as so-called organic metal complexes, for example, an organometallic compound of Ti, Ru, Rh, Zr, or the like.

More specifically, the hydrogenation catalysts disclosed in JP-S42-8704B, JP-S43-6636B, JP-S63-4841B, JP-H1-37970B, JP-H1-53851B, and JP-H2-9041B can be used. The hydrogenation catalyst is preferably a titanocene compound and/or a mixture with a reducing organometallic compound, for example. For the titanocene compound, the compound disclosed in JP-H8-109219A can be used. More specifically, compounds having at least one ligand with a (substituted) cyclopentadienyl skeleton, an indenyl skeleton, or fluorenyl skeleton, such as biscyclopentadienyltitanium dichloride and monopentamethylcyclopentadienyltitanium trichloride can be used. The reducing organometallic compounds include an organic alkali metal compound such as organic lithium, an organomagnesium compound, an organoalminun compound, an organoboron compound, and an organozinc compound.

The hydrogenation reaction is generally performed in a temperature range from 0°C to 200°C, and preferably from 30°C to 150C. The hydrogen pressure used for the hydrogenation reaction is preferably 0.1 to 15 MPa, more preferably 0.2 to 10 MPa, and still more preferably 0.3 to 5 MPa. The hydrogenation reaction time is usually three minutes to 10 hours, and preferably 10 minutes to five hours. For the hydrogenation reaction, any of a batch process, a continuous process, and a combination thereof can be used.

The catalyst residue is removed from the reaction solution after the hydrogenation reaction, if necessary, thus enabling the hydrogenated copolymer and the modified hydrogenated copolymer to be separated from the solvent. Examples of methods for separating them include: a method in which a polar solvent that is a poor solvent for the polymer, such as acetone or an alcohol, is added to the reaction solution after the hydrogenation to precipitate the polymer, followed by recovery of the polymer; a method in which the solution of the hydrogenated copolymer and the modified hydrogenated copolymer is poured into hot water while being stirred to remove the solvent by steam stripping, followed by recovery of the polymer; and a method in which the polymer solution is directly heated to distil off the solvent.

To the hydrogenated copolymer and the modified hydrogenated copolymer, various kinds of stabilizers can be added, examples of which include phenol type stabilizers, phosphorus type stabilizers, sulfur type stabilizers, and amine type stabilizers.

The content of the component A used for the resin composition according to the present invention is 1 to 20% by mass to the whole amount of the resin composition, preferably 5 to 20% by mass, and more preferably 10 to 20% by mass. If the content exceeds 20% by mass, the resin composition tends to have poorer heat conductivity and lower fire resistance, whereas if the content falls short of 1% by mass, the resin composition cannot achieve sufficient formability, and has insufficient strength when being made thin.

The component B used for the resin composition according to the present embodiment is a mineral oil-based softening agent for rubber, increasing in volume, and improving processability of a rubber, which is called as process oil or extender oil. The component B is typically a mixture composed of a compound having an aromatic ring, a compound having a naphthene ring, and a compound having a paraffin chain (for example, refer to "Diana Process Oil", a pamphlet issued by Idemitsu Kosan Co., Ltd., or "Rubber Industry Handbook" issued by The Society of Rubber Industry, Japan on November 15th, 1973, pp. 284-285).

Examples of the component B include silicone oils, synthesis oils, fluorinated oils, mineral oils, (petroleum-based oils), and synthetic oils. Preferred examples of the oils include paraffinic, naphthenic, and aromatic oils, and particularly preferred examples include paraffinic and naphthenic oils. The aromatic oils can negatively affect cold resistance and durability. The paraffinic oils are particularly preferably used among these oils, and paraffinic oil having the aromatic ring component in a small amount is particularly suitable.

The kinetic viscosity of the paraffinic oils at 40°C is preferably 100 mm²/sec or more, more preferably 100 to 10000 mm²/sec, and still more preferably 200 to 5000 mm²/sec. Examples of the paraffinic oils include "NA Solvent (brand name)" available from Nippon Oil and Fats Corporation, "Diana (trademark) Process Oil PW-90, and PW-380" available from Idemitsu Kosan Co., Ltd., "IP-SOLVENT 2835 (brand name)" available from Idemitsu Petrochemical Co., Ltd., and "Neothiosol (brand name)" available from Sanko Chemical Industry Co., Ltd.

The component B preferably has a flash point at 170°C to 300°C, and the weight-average molecular weight of 100 to 5000.

The content of the component B is 1 to 20% by mass to the whole amount of the resin composition, preferably 2 to 15% by mass, and more preferably 6 to 12% by mass. If the content exceeds 20% by mass, the softening agent for rubber tends to bleed out and the resin composition has lower fire resistance, whereas if the content falls short of 1% by mass, the resultant resin composition cannot achieve sufficient flexibility.

The component C used for the resin composition according to the present embodiment achieves heat conductivity, fire resistance, and electrical insulation in the composition. In addition, the component can enhance the strength of the composition, thus enabling the composition to be made thin by extrusion forming. The component is necessary for achieving the strength of the sheet thus formed.

The component C is aluminum hydroxide and may contain a small amount of impurity components (components other than the aluminum hydroxide) derived from raw materials.

Aluminum hydroxide is used because it has significant effects on fire resistance and function as heat conductive filler. The amount of heat absorption of aluminum hydroxide is approximately 1.97 kJ/g, which is a large value compared to approximately 1.31 kJ/g of magnesium hydroxide, and approximately 0.93 kJ/g of calcium hydroxide. Due to its characteristics of high fire resistance, aluminum hydroxide is used. Furthermore, the component C is aluminum hydroxide, because the resin composition in this case has higher toughness when it is formed into a thin sheet.

As for the hydroxide aluminum, hydroxide aluminum in carbon dioxide process, prepared by dissolving bauxite with an alkali aqueous solution and then introducing carbon dioxide thereto, or hydroxide aluminum in Bayer process, prepared by dissolving bauxite with an alkali aqueous solution and then adding seed crystal thereto, can be used. Because aluminum hydroxide is prepared by such methods, it usually contains components other than itself, such as SiO₂, Fe₂, O₃, and Na₂O. Therefore, aluminum hydroxide in the present embodiment includes aluminum hydroxide containing a small amount of impurities (the content of aluminum hydroxide is usually 99% by mass or more) as well as pure aluminum hydroxide.

The content of the component C is 70% by mass or more and 95% by mass or less to the whole amount of the resin composition, preferably 75% by mass or more and 93% by mass or less, and more preferably 80% by mass or more and 90% by mass or less. If the content falls short of 70% by mass, it is difficult to achieve heat conductivity and fire resistance.

The component C is preferably formed in particles whose average particle diameter is preferably 10 to 80 µm, which makes it possible to achieve heat conductivity, fire resistance and toughness effectively. More preferably, the average particle diameter is 30 to 80 µm.

The component C preferably contains two or more different aluminum hydroxides whose respective average particle diameters are 20 µm or larger and smaller than 20 µm. By containing different aluminum hydroxides with average particle diameters of 20 µm or larger and smaller than 20 µm, heat conductivity and fire resistance can be improved in a balanced manner. The weight ratio of particles with an average particle diameter of 20 µm or larger (a first aluminum hydroxide) and particles with an average particle diameter of smaller than 20 µm (a second aluminum hydroxide) is preferably 100/1 to 100/80, more preferably 100/10 to 100/50, and still more preferably 100/20 to 100/50. Each of the average particle diameters (µm) is a particle diameter on a volumetric basis measured by using a laser diffraction/scattering particle size distribution analyzer. The average particle diameter is usually measured in a state where aluminum hydroxide is dispersed in water or ethanol. When aluminum hydroxide is hard to disperse, dispersion can be promoted by using a surfactant agent. Homogenizer or ultrasonic waves can be used for the dispersion as appropriate. The concentration of aluminum hydroxide powder to be dispersed is usually 1% or less.

The component C has a concentration of Na₂O in the aluminum hydroxide of 0.2% by mass or less, more preferably 0.1 % by mass or less, and still more preferably 0.05% by mass or less. The content of Na₂O is measured by the X-ray fluorescent spectrometry. When the concentration of Na₂O in the aluminum hydroxide is 0.2% by mass or less, the composition has remarkably higher dielectric breakdown strength and still higher fire resistance as well.

The component C may be pretreated as appropriate. For example, an aluminum hydroxide whose surface is modified by a pretreatment with a silane coupling agent, titanate coupling agent, and stearic acid can be used.

The resin composition according to the present invention can contain (D) fluororesin and/or modified fluororesin (hereinafter, referred to as "component D").

For the component D, a tetrafluoroethylenepolymer, such as polytetrafluoroethylene, and a tetrafluoroethylene/propylene copolymer, which is a fluoropolymer having fibril-forming ability, is preferably used. Polytetrafluoroethylene is particularly preferably applicable.

Various types of fuluoropolymer, such as a fuluoropolymer in fine powder form, aqueous dispersion of fluoropolymers, and a powder-form mixture with the second resin of AS, PMMA, or the like can be used for the component D.

Examples of aqueous dispersion of fluoropolymers that is preferably applicable in the present embodiment include "Teflon 30J" available from DuPont-Mitsui Fluorochemicals Co., Ltd., and "Polyflon D-1", "Polyflon D-2", "Polyflon D-2C", and "Polyflon D-2CE" available from Daikin Industries Ltd.

In the present embodiment, a fluoropolymer (referred to as a modified fluororesin in the present invention) that is a powder-form mixture with the second resin of AS, PMMA, or the like can be preferably used for the component D. The technologies for the modified fluororesin are disclosed in JP-H9-95583A, JP-H11-49912A, JP-2000-143966A, and JP-2000-297189.

Particularly, acrylic modified polytetrafluoroethylene (PTFE) is preferably used for the modified fluororesin (component D). Examples of the modified fluororesins preferably used in the present invention include "Metablen A-3800" available from Mitsubishi Rayon Co., Ltd.

The content of the component D is 0.01% by mass to 5% by mass to the whole amount of the resin composition, preferably 0.1 % by mass to 2% by mass, and more preferably 0.3% by mass to 1.5% by mass. By containing the component D in an amount of 0.01 % by mass to 5% by mass, fire resistance, mechanical property, and stability of sheet formability (viscosity and roll adhesion) can be remarkably improved.

The resin composition according to the present embodiment may contain a tackifier if necessary without departing from an object of the present invention. The tackifier is added to fix electronic parts, semiconductor devices, or displays to heat dissipation devices when using the resin composition in a sheet form. The tackifiers that can be used for the present invention are not particularly restricted. Commonly known tackifiers are used such as: rosin-based resin (gum rosin, tall oil rosin, wood rosin, modified rosin-based resin (e.g., hydrogenated rosin, disproportionated rosin, polymerized rosin, and maleic rosin), rosin ester-based resin (e.g., rosin glycerin ester, hydrogenated rosin glycerin ester, rosin pentaerythritol ester, hydrogenated rosin pentaerythritol ester, super-hydrogenated rosin glycerin ester, and stabilized rosin pentaerythritol ester), and the like); petroleum-based resin (hydrocarbon-based, (e.g., aliphatic petroleum-based, aromatic petroleum-based, dichlo pentadiene-based, heat-sensitive, and aromatic modified aliphatic petroleum-based); aliphatic petroleum resin (C5), aromatic petroleum resin (C9), copolymer petroleum resin (C5/C9), alicyclic petroleum resin (e.g., hydrogenated, and dicyclopentadiene), terpene resin (e.g., α-pinene, β-pinene, d-limonene, aromatic modified, phenol modified terpene, polyterpene, and hydrogenated terpene); pure monomer resin (styrene/α-methylstyrene, α-methylstyrene/vinyltoluene, styrene, and (meta)acrylic); chromane-indene resin; phenol-based resin; and xylene resin. These tackifiers are used alone or in combination of two or more.

Particularly preferred examples of the tackifier include rosin-based resin (rosin-based resin, and modified rosin-based resin), terpene-based resin (terpene resin), and petroleum-based resin (petroleum-based resin, aliphatic petroleum resin, aromatic petroleum resin, copolymer petroleum resin, and alicyclic petroleum resin). The content of the tackifier in the heat conductive resin composition is not particularly restricted. Although the tackifier can be added to the composition according to a target viscosity, the content is preferably 1 to 20% by mass.

These tackifiers can be contained wholly in the composition, or on the surface layer of the sheet.

A fatty acid, a fatty acid salt, an antioxidant, a cross-linker, thermoplastic resin, filler other than metal hydroxide, fire-retardant material other than metal hydroxide, or the like can be added to the resin composition according to the present embodiment if necessary. Examples of the antioxidants include aldehydes, amines, and phenols. Examples of the cross-linkers include organic peroxide, epoxies, isocyanates, and di(meth)acrylates. Examples of the thermoplastic resin include polyethylene, polypropylene, (meth)acrylic resin, and polystyrene. Examples of the filler include carbon black, carbon fiber, graphite micro powder, glass fiber, aluminum oxide, boron nitride, silicon carbide, boron carbide, aluminum nitride, zinc oxide, aluminum, and copper. Examples of the fire-retardant materials include nitrogen fire-retardant material (e.g., triazine series), PPE (polyphenylene ether), silicone fire-retardant material, an aromatic carboxylic acid and a metal salt thereof, a boron compound, and a zinc compound.

The resin composition is preferably combined with a fabric such as a glass fiber cloth and organic fiber cloth. Particularly, the composition combined with a glass cloth is preferably used in terms of enhancement of the strength, when being made thin, dimensional stability, and fire resistance. With such a composition, it is possible to reduce the thermal resistance of the sheet and achieve an efficient heat conductive function because the composition can be used in a thin form.

The resin composition according to the present embodiment, which is highly filled with the component C, has heat conductivity. The heat conductivity is preferably 1.0 W/m·K or more, which is measured conforming to ASTM (American Society for Testing and Materials) D5470.

When evaluating the thermal resistance (units: °C/W) in a direction perpendicular to the sheet surface of the sheet-formed object made of the resin composition according to the present invention conforming to the above-described method, the evaluation value is preferably 10 or less, more preferably 7 or less, still more preferably 5 or less, particularly preferably 3 or less, and most preferably 2 or less. The thermal resistance can be reduced by making the thickness of the sheet smaller. The smaller the evaluation value is, the more efficiently heat can be conducted. Because the sheet made of the resin composition according to the present embodiment has enough toughness to be handled easily even in a thin form, it is extremely useful industrially.

Methods for kneading to produce the resin composition according to the present embodiment are not particularly restricted. For example, a blade type kneading machine (e.g., a kneader and a banbury mixer), a roll type kneading machine (e.g., two-roll, three-roll, roll mill, and taper roll), and a screw type kneading machine (e.g., an extruder) can be applicable. A pressure kneader, a banbury mixer, and an extruder, for example, are preferably used among these kneading machine.

The resin composition according to the present embodiment can be formed into a sheet with a thickness of 0.1 to 3 mm depending on intended uses. The sheet prepared by forming the resin composition of the present embodiment into a sheet preferably has a thickness of 0.1 to 0.8 mm, more preferably 0.1 to 0.6 mm, and still more preferably 0.1 to 0.4 mm. The thermal resistance [°C/W] in the sheet can be reduced by making its thickness smaller, which makes it possible to conduct heat efficiently. With the resin composition according to the present embodiment, such a sheet with a small thickness can be formed easily. Methods for forming the composition into a sheet are not particularly restricted, and the composition can be processed by, for example, extrusion forming, compression forming, and calendar forming. Extrusion forming and calendar forming are preferably applicable because the sheet can be formed continuously and be wound in these methods. The resin composition formed in a sheet can be wound in a roll with a release film or a transfer adhesive film sandwiched therebetween. The size of the sheet is not particularly restricted, and can be modified depending on intended uses. More preferably, the sheet is formed by: kneading and extruding components to a T die by an extruder to form a sheet, and then winding the sheet with a release film or a transfer adhesive film by a sheet rolling device. Although the extrusion conditions at this time differ depending on the composition and the width of the sheet to be formed, preferable conditions are as follows: the preset temperature of the extruder is 90°C to 190°C; the screw rotation speed is 5 to 80 rpm; and L/D (the ratio of the length of the screw to its diameter) is 20 or more.

The sheet also can be prepared by: dissolving and dispersing the composition in a solvent, casting the resultant solution on a film or an exfoliate paper and then volatilizing acid from the solvent, or impregnating a glass cloth or an organic fiber cloth with the solution and then removing the solvent.

The sheet according to the present embodiment can be preferably used for a heat conductive sheet.

The heat conductive sheet according to the present embodiment preferably satisfies V0 according to UL94 (the standard number 94 of Underwriters Laboratories Inc.). UL94 is a standard relating to inflammability tests for plastic materials used for parts of devices or appliances. If a material satisfies the standard, it is classified as a material with high fire resistance. Because the heat conductive composition according to the present embodiment is used for electrical appliances or the like, fire resistance is essential for the composition. For example, the composition containing aluminum hydroxide, which decomposes and releases water at 200°C or more, can achieve fire resistance. When being formed into a sheet with a thickness of 0.5 mm, for example, the composition according to the present embodiment can have fire resistance satisfying V0 according to UL94, as well as excellent heat conductivity and high dielectric breakdown property.

With these heat conductive sheets interposed between heat generating portions and heat dissipation components or heat sinks in electronic components or semiconductor devices, the generated heat can be dissipated efficiently. As a result, heat deterioration in the electronic components, the semiconductor devices, or displays is reduced, which makes it possible to decrease failures and increase their lives. Specific examples of the components and the devices include central processing units (CPUs) for computers, liquid crystal display backlights, plasma display panels, LED elements, organic EL elements, secondary batteries and their peripherals, heat dissipation units for electric motors, Peltier elements, inverters, and (high) power transistors.

The sheet according to the present embodiment preferably has yield stress of 1.0 MPa or more and rupture elongation of 30% or more, which are measured at 23°C and a rate of pulling of 100 mm/min conforming to ISO 527-1. Such a sheet is excellent in handling property (attachment and reattachment property in small width portions) especially when being formed into a thin sheet.

LED associated components, such as LED backlights and LED illuminations, tend to generate a large amount of heat, which leads to unequal heat generation. Thus, the components need to have structural designs to dissipate and even out the heat. By attaching the heat conductive sheet on the back side of an LED substrate, for example, and then attaching a heat sink (e.g., aluminum chassis) thereto, it is possible to dissipate heat from the LED substrate to the outside efficiently.

### [Examples]

The present invention will be described more specifically based on examples and comparative examples. The present invention, however, is not limited to the examples.

Components described below were used.

### [Materials]

### <Producing of Copolymer A-1 Containing a Conjugated Diene Unit and a Vinyl Aromatic Unit and Having Two Copolymer Blocks of the Vinyl Aromatic Unit>

The copolymer was produced by the polymerization method below.

### · Reaction Conditions, etc.

Reactor Vessel: A stirring device with an inner volume of 10 L, and a jacketed tank reactor were used.

Reaction Temperature: The temperature was maintained at 70°C in the process of copolymerization. The temperature was maintained at 65°C during hydrogenation reaction.

Hydrogenation Catalyst: A catalyst was used, which was prepared by: feeding 1 L of dried and purified cyclohexane in a reaction container purged with nitrogen for adjustment of a hydrogenation catalyst and adding 100 mmol of bis(η5-cyclopentadienyl)titanium dichloride thereto; stirring the mixture sufficiently, and adding an n-hexane solution containing 200 mmol of trimethylaluminum thereto; and then carrying out a reaction of the solution at room temperature for about three drays.

### Reaction Process

(i) Ten parts by mass of cyclohexane was fed to the reactor, and the temperature was adjusted at 70°C.
(ii) For the first stage reaction, 0.076 parts by mass of n-butyllitium and 0.4 mol of N,N,N',N'-tetramethylethylenediamine (hereinafter referred to as MEDA) with respect to 1 mol of n-butyllitium were added thereto.
(iii) A cyclohexane solution (monomer concentration of 22% by mass) containing eight parts by mass of styrene was added thereto for about three minutes, and then the reaction was carried out for 30 minutes after finishing the addition.
(iv) For the second stage reaction, a cyclohexane solution (monomer concentration of 22% by mass) containing 48 parts by mass of 1,3-butadiene and 36 parts by mass of styrene were fed to the reactor continuously at a constant rate for 60 minutes, and then the reaction was carried out for 30 minutes after finishing the addition.
(v) For the third stage reaction, a cyclohexane solution (monomer concentration of 22% by mass) containing eight parts by mass of styrene was added thereto for about three minutes, and then the reaction was carried out for 30 minutes after finishing the addition to produce a copolymer.
(vi) To the resultant copolymer, 100 ppm by mass of the hydrogenation catalyst equivalent to a titanium volume was added, and then a hydrogenation reaction was carried out at a hydrogen pressure of 0.7 MPa and a temperature of 65°C.
(vii) Methanol was added thereto after the reaction, and then 0.3% by mass of octadecyl-3-(3,5-di-t-butyl-4-hydroxyphenyl)-propionate was added to the copolymer as a stabilizer to produce a hydrogenated copolymer.

The obtained hydrogenated copolymer had a weight-average molecular weight of 16.5 × 10⁴, a molecular weight distribution of 1.2, and a hydrogenated rate of 99%. As a result of dynamic viscoelasticity measurement, the copolymer was found to have a peak temperature of tanδ at -15°C. As a result of DSC measurement, the copolymer was found to have no crystallization peak. In the pre-hydrogenated copolymer obtained after the third stage reaction, a content of the vinyl aromatic unit was 52% by mass, a content of copolymer blocks of vinyl aromatics was 16% by mass, and a vinyl bond content in 1,3-butadiene parts was 21 % by mass.

### < Copolymer A-2 Containing a Conjugated Diene Unit and a Vinyl Aromatic Unit and Having Two Copolymer Blocks of the Vinyl Aromatic Unit>

A styrene-ethylene/butylene-styrene block copolymer (SEBS) was used. The copolymer had a weight-average molecular weight of 7 × 10⁴, a molecular weight distribution of 1.1, and a hydrogenated rate of 99%. In the copolymer, a content of copolymer blocks of a vinyl aromatic unit was 20% by mass, and a vinyl bond content in 1,3-butadiene parts was 35% by mass. The copolymer had a peak temperature of tanδ at -40°C, which was measured by the dynamic viscoelasticity measurement, and had crystallization peak (temperature falling rate of -10 °C/min) at 4°C, which was measured by the DSC measurement.

### < Copolymer A-3 Containing a Conjugated Diene Unit and a Vinyl Aromatic Unit Without Requirements of Component A of the Present Application>

The copolymer is a hydrogenated copolymer having one copolymer block composed of a vinyl aromatic unit that is produced by the process described in (i) to (vii) conforming to the producing method described in A-1.

### · Reaction Process

The processes in (i) and (ii) were the same as those of A-1.

The process in (iii) was the same as that of A-1, except that the content of styrene was 18 parts by mass.

The process in (iv) was the same as that of A-1, except that the content of 1,3-butadiene was 33 parts by mass and the content of styrene was 49 parts by mass.

The copolymer A-3 underwent no process in (v).

The processes in (vi) and (vii) were the same as those of A-1.

The copolymer A-3 had a weight-average molecular weight of 10 × 10⁴, a molecular weight distribution of 1.1, and a hydrogenated rate of 99%. As a result of the dynamic viscoelasticity measurement, the copolymer was found to have a peak temperature of tanδ at 10°C. As a result of the DSC measurement, the copolymer was found to have no crystallization peak. In the copolymer, a content of the vinyl aromatic unit was 67% by mass, a content of a copolymer block composed of a vinyl aromatic unit was 18% by mass, and a vinyl bond content in 1,3-butadiene parts was 17% by mass.

### <(B) Softening Agent for Rubber>

Diana Process Oil (trademark) PW-380 (paraffinic process oil) available from Idemitsu Kosan Co., Ltd.

### <(C) Metal Hydroxide according to invention (Aluminum Hydroxide) (C-1)>

The average particle diameter and the content of Na₂O of C-1 are listed in Table 1. Its specific gravity is 2.4.

### <(C) Metal Hydroxide for reference (Magnesium Hydroxide) (C-2)>

KISUMA5A (trademark) available from Kyowa Chemical Industry Co., Ltd., with a particle diameter of 0.86 µm and specific gravity of 2.4

### <Filler (Aluminum Oxide) (C-3) Without Requirements of Component C of the Present Application>

AX35-125 (trademark) available from Micron Co., Ltd., with a particle diameter of 35 µm, specific gravity of 3.8, and specific surface area of 0.16 m²/g

### <Acrylic Modified PTFE>

Metablen (trademark) A-3800 available from Mitsubishi Rayon Co., Ltd.

### [Methods for Producing a Sheet]

### <Kneading>

1) The composition was kneaded by using a 3-liter small capacities dispersion mixer (available from Moriyama Company Ltd.) at 140°C for 12 minutes, and then pelletized by a plunger-type pelletizer.

### <Sheet Forming>

1) The composition was kneaded with a 3-inch-roll kneader at 150°C to be formed in a sheet. By hot press forming at 170°C, a press-formed sheet with a length of 120 mm, a width of 220 mm and a thickness of 0.5 mm was prepared.
2) By using the resin composition pellets prepared in the <kneading> process, a sheet with a width of 400 mm and a thickness of 0.3 mm was produced by a 50-mm single-axis sheet extrusion machine with a T die mounted thereon (PG50-32V, available from Plagiken Co., Ltd.) at a preset temperature for a cylinder and the T die of 150°C and a roll temperature of 80°C. The machine had three rolls whose surfaces were finished with mirror chrome plating, and the T die was set to extrude the composition from the bottom. The molten resin composition extruded from the T die was rolled between the first roll and the second roll, and then pulled out by the third roll. At this time, the sheet was rolled between the first roll and second roll to burst bubbles in the resin composition and control its thickness.

### [Methods of Measurement]

### <Average Particle Diameter>

The average particle diameters were measured by using a laser diffraction/scattering particle size distribution analyzer LA-910 (available from Horiba, Ltd.). Samples were dispersed in dispersion media by irradiating them with ultrasonic waves for one minute.

### <Content of Na₂O>

The content of Na₂O was measured by the fluorescent X-ray spectroscopy.

### <Fire resistance>

The fire resistance was measured conforming to UL94. Specimens were pieces with a length of 130 mm, a width of 13 mm, and thicknesses of 0.5 mm and 0.3 mm.

### <Heat Conductivity>

By using a resin material thermal resistance measurement device (available from Hitachi, Ltd.), the heat conductivity was measured by the steady state method conforming to ASTM (American Society for Testing and Materials) D5470. The measurement temperature was at 30°C, and the thickness of the specimens was 0.5 mm.

The thermal resistance [°C/W] was measured with sheets of respective thicknesses.

### <Dielectric Breakdown Strength>

The dielectric breakdown strength was measured at 23°C, in oil, and by the short-time method, conforming to JIS C2110. Test electrodes were Φ 25 cylinder/Φ 25 cylinder, and the thickness of the specimens was 1.0 mm.

### <Flex Resistance>

After bending the sheet at an angle of 180 degrees for three times, whether cracks occurred at the bent portions was checked visually. The thickness of the specimens was 0.5 mm. In terms of the flex resistance, the sheet with "no cracks at the bent portions or minimal cracks" was evaluated as A, the one with "a lot of cracks occurring at the bent portions" was evaluated as B, and the one with "a rupture at a part of the bent portions" was evaluated as C.

### <Forming Stability (1)>

The composition was formed into a sheet by using a single-axis extrusion machine at a preset temperature of 150°C (Labo Plastomill-type: 50M, and screw-type: D2020, available from Toyo Seiki Seisaku-Sho, Ltd.), and using a T die with a width of 120 mm (available from Toyo Seiki Seisaku-Sho, Ltd.) whose lip thickness was adjusted to 1.0 mm. The forming stability was evaluated by checking the appearance of the sheet-formed products and the bubble release visually. In terms of the forming stability, the sheet with "no bubble release" was evaluated as A, the one with "bubble release in a small amount" was evaluated as B, and the one with "bubble release in a large amount" was evaluated as C. The bubbles tend to remain in the sheet even after the sheet is rolled, making the sheet likely to be torn when being made thin. Thus, the sheet with bubble release in a large amount is not recommended.

### <Forming Stability (2)>

In the sheet forming process 2), the forming stability of the sheet with a thickness of 0.3 mm was evaluated. In terms of the sheet rupture in producing the sheet, when the sheet drawing rate was 1.5 m/min, the sheet "which was able to be formed into a sheet without being torn for 100 m or more" was evaluated as A, the one "which was able to be formed into a sheet without being torn for 5 m to 100 m" was evaluated as B, and the one "which was torn within 5 m" was evaluated as C. In terms of the stickiness to the roll, when the sheet drawing rate was 1.5 m/min in the same manner, the sheet "which stuck to the roll, but was able to be formed into a sheet with the same thickness continuously because of its sufficient strength" was evaluated as A, the one "which stuck to the roll, and was often wound therearound because of its insufficient strength" was evaluated as B, and the one "which stuck to the roll, and was wound therearound because its strength was too small to be drawn" was evaluated as C. In terms of the thickness variation, with respect to a nominal thickness of 0.3 mm, the sheet "within a variation range of ±20%" was evaluated as A, the one "in excess of a variation range of ±20%" was evaluated as B, and the one "out of control because the sheet was not able to be formed into a sheet continuously" was evaluated as C.

### <Appearance of the Sheet>

The sheet was produced by forming the composition into pellets, and then using the 50-mm single-axis sheet extrusion machine with a T die mounted thereon (PG50-32V, available from Plagiken Co., Ltd.) at a preset temperature for the cylinder and the T die of 150°C and a roll temperature of 80°C. The sheet was checked visually to evaluate the surface smoothness and the bleeding of the component B (oil component). In terms of the smoothness of the sheet surface, when sticking "Saran Wrap (trademark)" available from Asahi Kasei Home Products Corporation thereto, the sheet "which adhered to Saran Wrap easily, and had adhesion when being peeled off" was evaluated as A, the one "which had adhesion if being rubbed against Saran Wrap" was evaluated as B, and the one "which had no adhesion" was evaluated as C. In terms of the bleeding of the component B on the sheet surface, the sheet "in which no oil component bleeding even after being left in an oven at 100°C for 24 hours" was evaluated as A, the one "in which the oil component bleeding after being left in an oven at 100°C for 24 hours" was evaluated as B, and the one "in which the oil component bleeding in a certain time after being formed into a sheet" was evaluated as C.

### <Tensile Property>

Conforming to JIS-K7161 (ISO 527-1), the yield stress, the rupture stress (units: MPa), and the rupture elongation (units: %) were measured in a 50% RH condition at 23°C and a rate of pulling of 100 mm/min. The measurement was carried out with specimens having a width of 25 mm and a thickness of 0.5 mm. The distance between chucks was 30 mm.

### [Examples 1 to 4 and Comparative Examples 1 to 3] (Example 3 for reference)

In examples 1 to 4 and comparative examples 1 to 3, the resin compositions and the sheets using the same were produced by the compositions listed in Table 1 (the content of filler is indicated in Table 1, and was 60% by mass in examples 1 to 3 and comparative examples 1 and 2). The tensile property, the continuous formability of the sheet with a thickness of 0.3 mm, the smoothness on the sheet surface, the bleeding of the oil component (component B) to the sheet surface, the thermal resistance in a direction perpendicular to the sheet surface (with thicknesses of 0.5 mm and 0.3 mm), and the fire resistance of the sheets were measured. The results are listed in Table 1. The relationships between the strain and the stress in the tensile tests for example 1, example 2 and comparative example 1 are illustrated in FIG. 1.

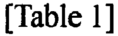

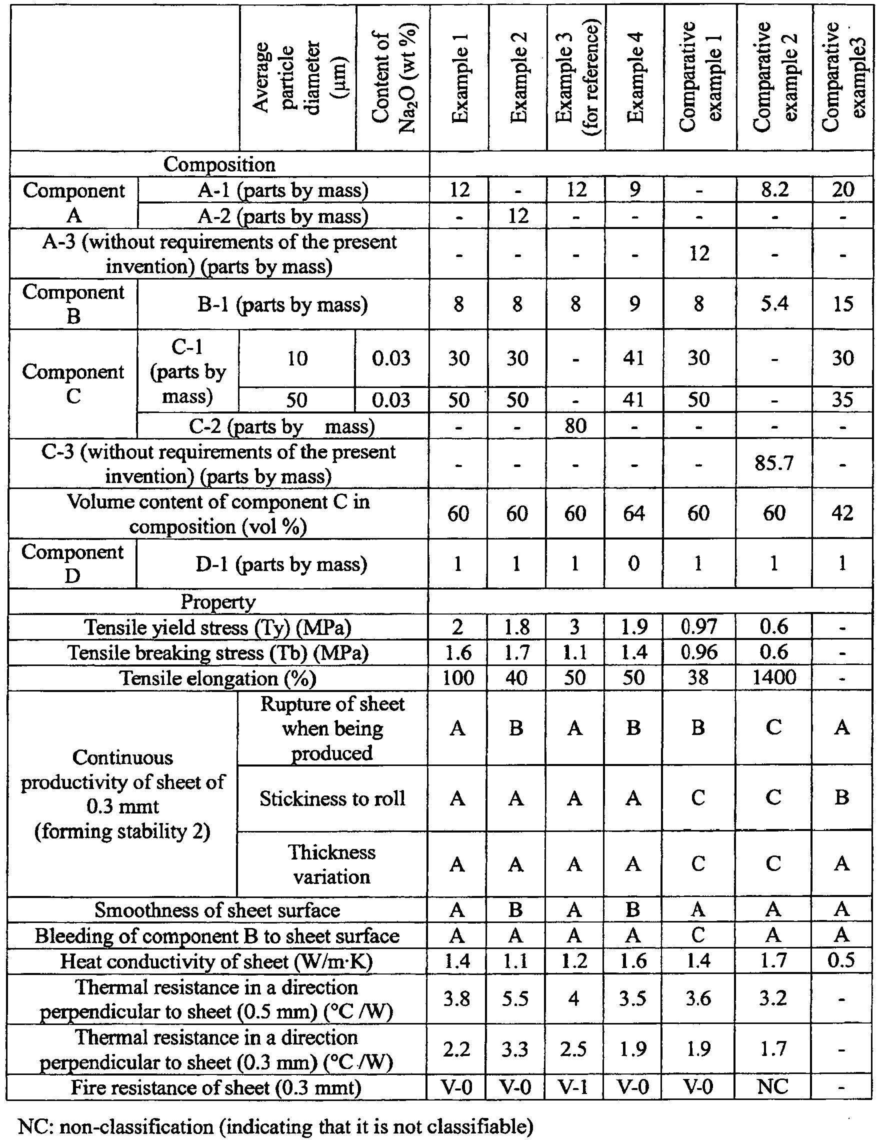

Example 1, which is a composition using A-1, has high strength and excellent elongation when being formed into a sheet. With example 1, a thin sheet (with a thickness of 0.3 mm) can be produced continuously. Example 2 is a composition using A-2. The sheet using A-2 (SEBS) has high yield strength, but is poor in elongation. As a result, the sheet tended to be ruptured compared to example 1 when used for continuously producing a thin sheet. The obtained sheet in example 2 tended to have slightly low surface smoothness compared to that of example 1. The surface smoothness is preferably made high to improve the adhesion when interposing the sheet between elements serving as a heat source and heat sink. The reason for the low surface smoothness in using A-2 (SEBS) is considered to be a larger volume contraction because of the crystallization than that of A-1, which is caused by the crystallization property of the ethylene-butylene copolymer portions serving as a soft segment. Reference Example 3 is a composition using C-2 (magnesium hydroxide). The sheet has high strength and excellent sheet formability. The sheet using C-2 tended to have slightly-low fire resistance compared to the sheet using C-1. Example 4 has a larger content of the component C than that of example 1, which deteriorated elongation of the sheet.

Comparative example 1, which is a composition using A-3 without the requirements of the present application, has low yield strength and poor elongation. When producing a 0.3 mm-thick sheet with comparative example 1 continuously, it is difficult to produce the sheet stably because of the low strength and poor elongation of the sheet. Furthermore, oil bleeding out on the surface of the sheet. Comparative example 2 is a result when using C-3 alumina without the requirements of the present application. The sheet with excellent elongation and low yield strength was likely to be whitened as it was elongated, which led to void formation therein. The sheet has low fire resistance. Comparative example 3, which is a composition without the requirements of the quantitative ratio of the component C, has poor heat conductivity.

### [Examples 5 to 17] (Examples 9, 10 and 15-17 for reference)

In examples 5 to 17, compositions and sheets with a thickness of 0.3 mm or 0.5 mm were produced by the compositions listed in Table 2 and Table 3. The fire resistance, the heat conductivity, the dielectric breakdown strength, the flex resistance, the forming stability, and the tensile yield stress of the sheets were measured. The results are listed in Table 2 and Table 3. In terms of the flex resistance, the sheet with "no cracks at the bent portions or minimal cracks" was evaluated as A, the one with "a lot of cracks caused at the bent portions" was evaluated as B, and the one with "a rupture at a part of the bent portions" was evaluated as C. In terms of the forming stability, the sheet with "no bubble release" was evaluated as A, the one with "bubble release in a small amount" was evaluated as B, and the one with "bubble release in a large amount" was evaluated as C.

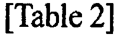

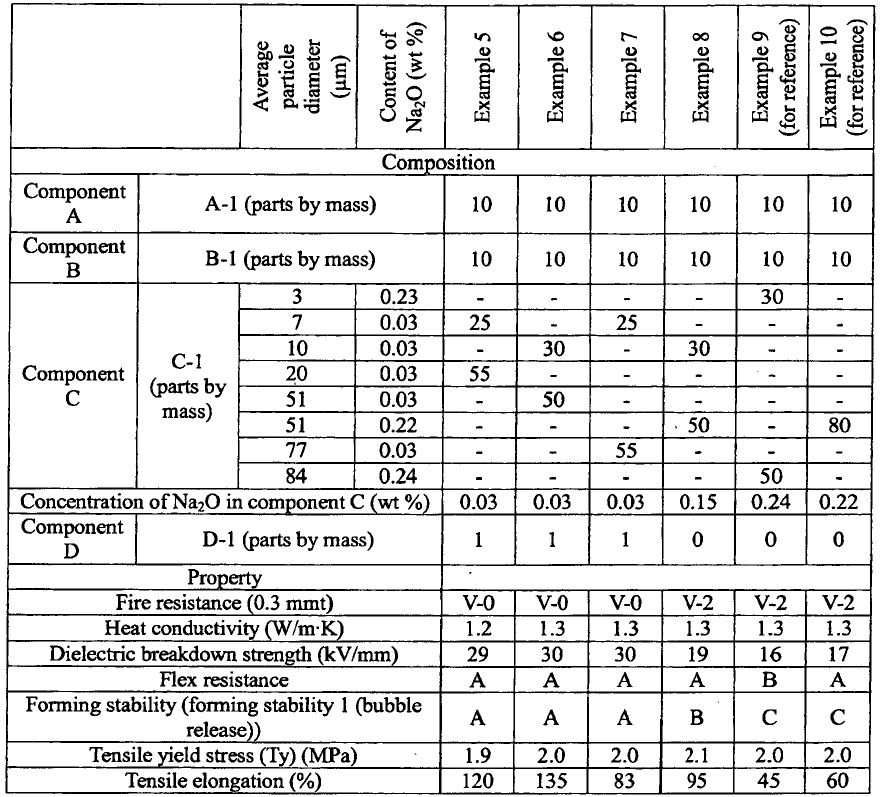

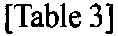

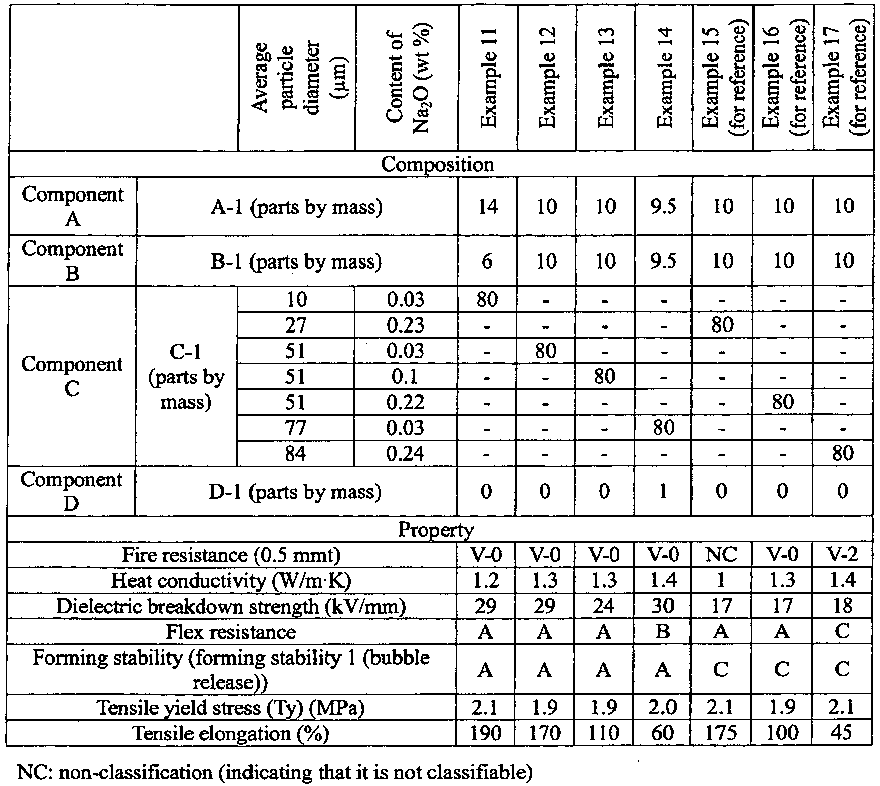

In examples 5 to 10, the sheets with a thickness of 0.3 mm were able to be formed continuously. By comparing examples 5, 6, and 7 to examples 8, 9, and 10, it is found that the dielectric breakdown strength and the forming stability of the sheets tend to be lowered as the concentration of Na₂O in the component C increases (in other words, the bubble release tends to be caused). In examples 5 to 10, the sheets with a thickness of 0.3 mm were used to evaluate the fire resistance. With the component D appropriately composed, the sheets tended to achieve V-0 fire resistance stably.

In examples 11 to 17, the sheets with a thickness of 0.5 mm were used to evaluate the fire resistance. The sheet using the component C with an average particle diameter of 80 µm or more tends to have lower fire resistance. By comparing examples 11 to 14 to examples 15 to 17, it is found that the concentration of Na₂O is to be kept low to enhance the dielectric breakdown strength. In examples 11 to 17, the sheets with a thickness of 0.3 mm were able to be formed continuously.

### [Example 18]

A sheet with a thickness of 100 µm was produced by: dispersing a composition made of 12% by mass of component A-1, 8% by mass of component B-1, and 80% by mass of aluminum hydroxide (average particle diameter of 10 µm, content of Na₂O of 0.03% by mass) in toluene with a solid content concentration of 50% by mass; impregnating a glass cloth (part number 1037, IPC standard product, available from Asahi Kasei Electronics, Co., Ltd.) with the resultant mixture and drying the cloth at 120°C; and interposing the cloth between PET release films (35 µm thick) and pressing them by a vacuum-press forming machine at 120°C (20 kgf/cm²). The sheet thus obtained had thermal resistance of 2.5 [°C/W], dielectric breakdown voltage of 2.3 [kv] (measured with the sheet of 100 µm thick), and fire resistance of V-0 (measured with the sheet of 100 µm thick). The sheet was flexible, tough, and excellent in dimensional stability and handling property (reattachment property).

### [Example 19]

When applying the sheet of 0.3 mmt thick obtained in example 1 to a gap between a substrate mounted with LEDs and an aluminum flame fixing the substrate, and measuring the temperature under the substrate, the temperature under the substrate (directly measured with a thermocouple) was found to be dropped by 10°C compared to the case without using the sheet. In other words, the sheet in example 1 can reduce the temperature of LEDs in continuous use effectively.

The resin composition described above has high toughness and excellent heat conductivity when being made thin. The resin composition is a heat conductive composition that has high flex resistance and excellent forming stability in a thin sheet as well. Electronic components, semiconductor devices, or displays with the resin composition interposed between a heating element and heat dissipater are preferably applicable to applications in which high heat conductivity is required compared to related-art devices.

## Claims

1. A resin composition comprising:
1 to 20% by mass of (A) a copolymer containing a conjugated diene unit and a vinyl aromatic compound unit;
1 to 20% by mass of (B) a softening agent for rubber; and
70 to 95% by mass of (C) aluminum hydroxide,
wherein (A) the copolymer containing the conjugated diene unit and the vinyl aromatic compound unit includes a plurality of polymer blocks of the vinyl aromatic compound unit, and
wherein (C) the aluminum hydroxide contains Na₂O in a concentration of 0.2% by mass or less.

2. The resin composition according to claim 1, wherein (C) the aluminum hydroxide is formed in particles whose average particle diameter is 10 to 80 µm.

3. The resin composition according to claim 1 or 2, wherein (C) the aluminum hydroxide is formed in particles and includes a first aluminum hydroxide whose average particle diameter is 20 µm or larger and a second aluminum hydroxide whose average particle diameter is smaller than 20 µm, and wherein a weight ratio of the first aluminum hydroxide to the second aluminum hydroxide being 100/1 to 100/80.

4. The resin composition according to any one of claims 1 to 3, wherein (A) the copolymer containing the conjugated diene unit and the vinyl aromatic compound unit is a hydrogenated copolymer prepared by hydrogenating a copolymer of conjugated diene and a vinyl aromatic compound and/or a modified hydrogenated copolymer prepared by introducing a functional group to a copolymer of conjugated diene and a vinyl aromatic compound and hydrogenating the copolymer.

5. The resin composition according to any one of claims 1 to 4, wherein (A) the copolymer containing the conjugated diene unit and the vinyl aromatic compound unit contains the vinyl aromatic compound unit in an amount of 30% by mass or more and 90% by mass or less.

6. The resin composition according to any one of claims 1 to 5, wherein (A) the copolymer containing the conjugated diene unit and the vinyl aromatic compound unit contains the polymer blocks of the vinyl aromatic compound unit in an amount of 40% by mass or less.

7. The resin composition according to any one of claims 1 to 6, wherein (A) the copolymer containing the conjugated diene unit and the vinyl aromatic compound unit has a weight-average molecular weight of 5 x 10⁴ to 100 x 10⁴.

8. The resin composition according to any one of claims 1 to 7, wherein (A) the copolymer containing the conjugated diene unit and the vinyl aromatic compound unit includes a random copolymer block of conjugated diene and a vinyl aromatic compound.

9. The resin composition according to any one of claims 1 to 8, further comprising:
(D) fluororesin and/or modified fluororesin in an amount of 0.01 to 5% by mass.

10. A sheet produced by forming the resin composition according to any one of claims 1 to 9 into a sheet with a thickness of 0.8 mm or smaller.

11. The sheet according to claim 10, wherein the sheet includes a glass fiber cloth and/or an organic fiber cloth.

12. The sheet according to claim 10 or 11, wherein the sheet is used for an LED component.

13. The sheet according to claim 10,
wherein a resin composition comprises 1 to 20% by mass of (A) a copolymer containing a conjugated diene unit and a vinyl aromatic compound unit, 1 to 20% by mass of (B) a softening agent for rubber, and 70 to 95% by mass of (C) aluminum hydroxide,
(A) the copolymer containing the conjugated diene unit and the vinyl aromatic compound unit includes a plurality of polymer blocks of the vinyl aromatic compound unit and a random copolymer block of conjugated diene and a vinyl aromatic compound, and
wherein (C) the aluminum hydroxide contains Na₂O in a concentration of 0.2% by mass or less.

## Patentansprüche

1. Harzzusammensetzung, umfassend:
1 bis 20 Massen-% eines Copolymers (A), welches eine konjugierte Dieneinheit und eine vinylaromatische Verbindungseinheit enthält,
1 bis 20 Massen-% eines Weichmachers (B) für Kautschuk und
70 bis 95 Massen-% Aluminiumhydroxid (C),
wobei das Copolymer (A), welches die konjugierte Dieneinheit und die vinylaromatische Verbindungseinheit enthält, eine Vielzahl von Polymerblöcken der vinylaromatischen Verbindungseinheit beinhaltet, und
wobei das Aluminiumhydroxid (C) Na₂O in einer Konzentration von 0,2 Massen-% oder weniger enthält.

2. Harzzusammensetzung nach Anspruch 1, wobei das Aluminiumhydroxid (C) teilchenförmig ist, wobei die Teilchen einen durchschnittlichen Teilchendurchmesser von 10 bis 80 µm haben.

3. Harzzusammensetzung nach Anspruch 1 oder 2, wobei das Aluminiumhydroxid (C) teilchenförmig ist und ein erstes Aluminiumhydroxid enthält, dessen durchschnittlicher Teilchendurchmesser 20 µm oder größer ist, und ein zweites Aluminiumhydroxid, dessen durchschnittlicher Teilchendurchmesser kleiner als 20 µm ist, und wobei das Gewichtsverhältnis des ersten Aluminiumhydroxids zum zweiten Aluminiumhydroxid 100/1 bis 100/80 ist.

4. Harzzusammensetzung nach einem der Ansprüche 1 bis 3, wobei das Copolymer (A), welches die konjugierte Dieneinheit und die vinylaromatische Verbindungseinheit enthält, ein hydriertes Copolymer ist, hergestellt durch Hydrieren eines Copolymers eines konjugierten Diens und einer vinylaromatischen Verbindung, und/oder ein modifiziertes hydriertes Copolymer, hergestellt durch Einführen einer funktionalen Gruppe in ein Copolymer eines konjugierten Diens und einer vinylaromatischen Verbindung und Hydrieren des Copolymers.

5. Harzzusammensetzung nach einem der Ansprüche 1 bis 4, wobei das die konjugierte Dieneinheit und die vinylaromatische Verbindungseinheit enthaltende Copolymer (A) die vinylaromatische Verbindungseinheit in einer Menge von 30 Massen-% oder mehr und 90 Massen-% oder weniger enthält.

6. Harzzusammensetzung nach einem der Ansprüche 1 bis 5, wobei das Copolymer (A), welches die konjugierte Dieneinheit und die vinylaromatische Verbindungseinheit enthält, die Polymerblöcke der vinylaromatischen Verbindungseinheit in einer Menge von 40 Massen-% oder weniger enthält.

7. Harzzusammensetzung nach einem der Ansprüche 1 bis 6, wobei das die konjugierte Dieneinheit und die vinylaromatische Verbindungseinheit enthaltende Copolymer (A) ein Gewichtsmittel des Molekulargewichts von 5 x 10⁴ bis 100 x 10⁴ aufweist.

8. Harzzusammensetzung nach einem der Ansprüche 1 bis 7, wobei das die konjugierte Dieneinheit und die vinylaromatische Verbindungseinheit enthaltende Copolymer (A) einen statistischen Copolymerblock von konjugiertem Dien und einer vinylaromatischen Verbindung enthält.

9. Harzzusammensetzung nach einem der Ansprüche 1 bis 8, welche weiterhin umfasst:
(D) ein Fluorharz und/oder modifiziertes Fluorharz in einer Menge von 0,01 bis 5 Massen-%.

10. Blatt/Folie/Platte, hergestellt durch Formen der Harzzusammensetzung nach einem der Ansprüche 1 bis 9 zu einem/einer Blatt/Folie/Platte mit einer Dicke von 0,8 nm oder kleiner.

11. Blatt/Folie/Platte nach Anspruch 10, wobei das/die Blatt/Folie/Platte ein Glasfasergewebe und/oder ein organisches Fasergewebe enthält.

12. Blatt/Folie/Platte nach Anspruch 10 oder 11, wobei das/die Blatt/Folie/Platte für eine LED-Komponente verwendet wird.

13. Blatt/Folie/Platte nach Anspruch 10,
wobei die Harzzusammensetzung 1 bis 20 Massen-% eines Copolymers (A), enthaltend eine konjugierte Dieneinheit und einen vinylaromatische Verbindungseinheit, 1 bis 20 Massen-% eines Weichmachers für Kautschuk (B) und 70 bis 95 Massen-% Aluminiumhydroxid (C) umfasst,
das Copolymer (A), welches die konjugierte Dieneinheit und die vinylaromatische Verbindungseinheit enthält, eine Vielzahl von Polymerblöcken der vinylaromatischen Verbindungseinheit und einen statistischen Copolymerblock von konjugiertem Dien und einer vinylaromatischen Verbindung enthält, und
wobei das Aluminiumhydroxid (C) Na₂O in einer Konzentration von 0,2 Massen-% oder weniger enthält.

## Revendications

1. Composition de résine comprenant :
de 1 à 20 % en masse de (A) un copolymère contenant une unité de diène conjugué et une unité de composé aromatique vinylique ;
de 1 à 20 % en masse de (B) un plastifiant pour caoutchouc ; et
de 70 à 95 % en masse de (C) hydroxyde d'aluminium,
dans laquelle (A) le copolymère contenant l'unité de diène conjugué et l'unité de composé aromatique vinylique comprend plusieurs séquences polymères de l'unité de composé aromatique vinylique, et
dans laquelle (C) l'hydroxyde d'aluminium contient Na₂O dans une concentration de 0,2 % en masse ou inférieure.

2. Composition de résine selon la revendication 1, dans laquelle (C) l'hydroxyde d'aluminium est formé de particules dont le diamètre moyen de particules est de 10 à 80 µm.

3. Composition de résine selon la revendication 1 ou 2, dans laquelle (C) l'hydroxyde d'aluminium est formé en particules et comprend un premier hydroxyde d'aluminium dont le diamètre moyen de particules est de 20 µm ou supérieur et un second hydroxyde d'aluminium dont le diamètre moyen de particules est inférieur à 20 µm, et dans laquelle un rapport massique du premier hydroxyde d'aluminium au second hydroxyde d'aluminium est de 100/1 à 100/80.

4. Composition de résine selon l'une quelconque des revendications 1 à 3, dans laquelle (A) le copolymère contenant l'unité de diène conjugué et l'unité de composé aromatique vinylique est un copolymère hydrogéné préparé par hydrogénation d'un copolymère de diène conjugué et d'un composé aromatique vinylique et/ou un copolymère hydrogéné modifié préparé par introduction d'un groupe fonctionnel dans un copolymère de diène conjugué et d'un composé aromatique vinylique et hydrogénation du copolymère.

5. Composition de résine selon l'une quelconque des revendications 1 à 4, dans laquelle (A) le copolymère contenant l'unité de diène conjugué et l'unité de composé aromatique vinylique contient l'unité de composé aromatique vinylique dans une quantité de 30 % en masse ou supérieure et de 90 % en masse ou inférieure.

6. Composition de résine selon l'une quelconque des revendications 1 à 5, dans laquelle (A) le copolymère contenant l'unité de diène conjugué et l'unité de composé aromatique vinylique contient des séquences polymères de l'unité de composé aromatique vinylique dans une quantité de 40 % en masse ou inférieure.

7. Composition de résine selon l'une quelconque des revendications 1 à 6, dans laquelle (A) le copolymère contenant l'unité de diène conjugué et l'unité de composé aromatique vinylique présente une masse moléculaire moyenne en masse de 5 x 10⁴ à 100 x 10⁴.

8. Composition de résine selon l'une quelconque des revendications 1 à 7, dans laquelle (A) le copolymère contenant l'unité de diène conjugué et l'unité de composé aromatique vinylique comprend une séquence copolymère statistique de diène conjugué et d'un composé aromatique vinylique.

9. Composition de résine selon l'une quelconque des revendications 1 à 8, comprenant de plus :
(D) une fluororésine et/ou une fluororésine modifiée dans une quantité de 0,01 à 5 % en masse.

10. Feuille produite par formation de la composition de résine selon l'une quelconque des revendications 1 à 9 en une feuille avec une épaisseur de 0,8 mm ou inférieure.

11. Feuille selon la revendication 10, dans laquelle la feuille comprend un tissu de fibres de verre et/ou un tissu de fibres organiques.

12. Feuille selon la revendication 10 ou 11, dans laquelle la feuille est utilisée pour un constituant LED.

13. Feuille selon la revendication 10,
dans laquelle une composition de résine comprend de 1 à 20 % en masse de (A) un copolymère contenant une unité de diène conjugué et une unité de composé aromatique vinylique, de 1 à 20 % en masse de (B) un plastifiant pour caoutchouc, et de 70 à 95 % en masse de (C) hydroxyde d'aluminium,
(A) le copolymère contenant l'unité de diène conjugué et l'unité de composé aromatique vinylique comprend plusieurs séquences polymères de l'unité de composé aromatique vinylique et une séquence copolymère statistique de diène conjugué et d'un composé aromatique vinylique, et
dans laquelle (C) l'hydroxyde d'aluminium contient Na₂O dans une concentration de 0,2 % en masse ou inférieure.
